# EUROPEAN PATENT APPLICATION

(11) **EP 2 209 357 A1**
(43) Date of publication of application: **21.07.2010**
(21) Application number: 10150091.6
(22) Date of filing: 05.01.2010
(51) Int. Cl.: H05K 1/02

(54) **Printed circuit board**

(30) Priority: 16.01.2009 KR 20090003843
(71) Applicant: SAMSUNG ELECTRONICS CO., LTD., Suwon-si Gyeonggi-do 442-742 (KR)
(72) Inventor: Han, Jang Soon, Gyeonggi-do (KR); Lee, Seung Myen, Gyeonggi-do (KR)
(74) Representative: D'Halleweyn, Nele Veerle Trees Gertrudis

(57) **Abstract**

A printed circuit board (PCB) reduces a simultaneous switching noise (SSN) causing power noise, thereby reducing radiated electromagnetic interference (EMI). In a double-layered PCB, a first substrate is arranged in parallel with a second substrate while being spaced apart from the second substrate by a predetermined distance. The first substrate includes a ground plane, which is deposited over an entirety of the first substrate. The second substrate includes a power plane deposited at a position of a component mounted to the printed circuit board (PCB) to transmit power to the component. Thus, the power trace of the PCB is simplified in structure, thereby reducing EMI radiation noise.

## Description

### BACKGROUND

### 1. Field of the Invention

The present general inventive concept relates to a printed circuit board for reducing radiated electromagnetic interference (EMI).

### 2. Description of the Related Art

Generally, a driver and a receiver may be mounted to a printed circuit board (PCB). For example, the driver and the receiver may be a memory controller and a memory each implemented in the form of a chip, respectively. A trace for transmitting a data bus signal is arranged between the driver and the receiver on the PCB. The trace is printed as a conductive medium on the PCB. The data bus signal generated from the driver is switched with a predetermined clock rate, and the switched signal is transmitted to the receiver. The data bus signal may be composed of n bits (n-bit), such that n drivers, receivers, and traces are mounted on the PCB. A series resistor for matching impedance between the driver and receiver is connected in series to each trace. In this case, each trace may be classified into a first trace and a second trace on the basis of the series resistor.

In the meantime, current provided from a power layer of the PCB is instantaneously changed when a certain integrated circuit (IC) is switched, such that the current flowing in a ground layer is abruptly changed, resulting in voltage fluctuation. This voltage fluctuation is called simultaneous switching noise (SSN). Due to this SSN, the current flowing in the driver is reduced, such that the driver is unable to implement perfect drive performance, and such that a system logic error such as a glitch arises. As a result, the reliability of system performance is deteriorated and unexpected EMI also occurs.

### SUMMARY

The present general inventive concept provides a printed circuit board (PCB) to reduce simultaneous switching noise (SSN) generated from the PCB by simplifying a power trace formed on the PCB.

The present general inventive concept also provides an improved decoupling capacitor connection structure for reducing the SSN generated from the PCB.

Additional features and utilities of the present general inventive concept will be set forth in part in the description which follows and, in part, will be obvious from the description, or may be learned by practice of the general inventive concept.

Exemplary embodiments of the present general inventive concept may be achieved by providing a double-layered printed circuit board (PCB) in which a first substrate is arranged parallel to a second substrate and is spaced apart from the second substrate by a predetermined distance including the first substrate including a ground plane deposited over the first substrate, and the second substrate including a power plane deposited at a position of a component mounted to the printed circuit board (PCB) to transmit power to the component.

The second substrate may include a signal trace and a power trace to transmit signals and power to the component.

The first substrate may further include a decoupling capacitor, and a power pin of the component mounted to the second substrate may be connected to the decoupling capacitor through a via.

The second substrate further may include a power supply to provide the power plane with power, and the power plane may be connected to the power supply through a power trace.

A decoupling capacitor may be mounted to a start point of the power trace transmitting power from the power supply to the power plane.

A decoupling capacitor may be mounted to an end point of the power trace transmitting power from the power supply to the power plane.

Exemplary embodiments of the present general inventive concept may also be achieved by providing a printed circuit board (PCB) including one or more power planes deposited at a position of a component mounted to the PCB to provide power to the component, and a power trace connected to the power plane to provide the power planes with power.

The power trace may be connected to the power plane through an edge having no pin connected to the component.

The printed circuit board (PCB) may include a first substrate and a second substrate, which are arranged in parallel while being spaced apart from each other by a predetermined distance, to form a double-layered structure.

The first substrate may include a decoupling capacitor, and a ground plane may be deposited over the first substrate.

The component may be mounted on the second substrate, and a power pin of the component may be connected to the decoupling capacitor through a via.

The second substrate may have a power supply to provide the power plane with power, and the power supply may transmit the power to the power plane through the power trace.

A decoupling capacitor may be mounted to a start point of the power trace transmitting power from the power supply to the power plane.

A decoupling capacitor may be mounted to an end point of the power trace transmitting power from the power supply to the power plane.

Exemplary embodiments of the present general inventive concept may also be achieved by providing a printed circuit board (PCB), including a first substrate including a ground plane deposited over the first substrate, a second substrate arranged parallel to the first substrate and spaced apart from the first substrate by a predetermined distance, including a power plane, a power trace connected to the power plane to provide the power plane with power, and a component mounted to the PCB, wherein the power plane is interposed between the component and the substrate to transmit power to the component.

### BRIEF DESCRIPTION OF THE DRAWINGS

These and/or other features and utilities of the present general inventive concept will become apparent and more readily appreciated from the following description of the exemplary embodiments, taken in conjunction with the accompanying drawings of which:
FIG. 1 is a schematic diagram of a printed circuit board (PCB) according to an exemplary embodiment of the present general inventive concept;
FIG. 2 is a top view of a printed circuit board (PCB) according to an exemplary embodiment of the present general inventive concept;
FIG. 3 illustrates a position of a decoupling capacitor mounted to a PCB according to an exemplary embodiment of the present general inventive concept;
FIG. 4 illustrates a position of a decoupling capacitor according to an exemplary embodiment of the present general inventive concept;
FIG. 5 illustrates an installation structure of a decoupling capacitor in a PCB mounted to the PCB according to an exemplary embodiment of the present general inventive concept;
FIG. 6A shows a power trace of a printed circuit board (PCB) according to the related art, and FIG. 6B shows a power trace of a printed circuit board (PCB) according to an exemplary embodiment of the present general inventive concept; and
FIGS. 7A and 7B are graphs showing EMI data of a printed circuit board (PCB) according to an exemplary embodiment of the present general inventive concept.

### DETAILED DESCRIPTION OF THE EMBODIMENTS

Reference will now be made in detail to exemplary embodiments of the present general inventive concept, examples of which are illustrated in the accompanying drawings, wherein like reference numerals refer to like elements throughout. The exemplary embodiments are described below in order to explain the present general inventive concept by referring to the figures.

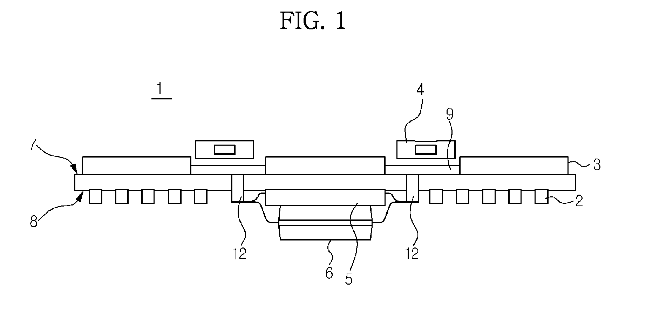

FIG. 1 is a schematic diagram of a printed circuit board (PCB) 1 according to an exemplary embodiment of the present general inventive concept.

Referring to FIG. 1, the printed circuit board (PCB) 1 includes a signal trace 2, a ground plane 3, a decoupling capacitor 4, a power plane 5, and a component 6.

The PCB 1 can be a double-layered printed circuit board in which a first substrate 7 is arranged parallel to a second substrate 8 while being spaced apart from the second substrate 8 by a predetermined distance D. The ground plane 3 can be deposited over the entirety of the first substrate 7. The ground plane 3 can provide a ground potential to components of the PCB 1 while reducing the distance of a connection between a component and the ground plane 3. The decoupling capacitor 4 can be mounted to the first substrate 7 and is connected with a power pin of the component 6 through a via (not illustrated). The power plane 5, the signal trace 2, and the component 6 may be mounted to the second substrate 8.

The signal trace 2 serves as a signal transmission path, and has a line or a path in the PCB 1 to transport signals to the component 6.

The ground plane 3 is deposited over the entirety of the first substrate 7, such that it ensures a stable return current path of a high-speed trace as in a double data rate (DDR) clock, a universal serial bus (USB), a high definition multimedia interface (HDMI), and the like. As a result, the ground plane 3 may prevent electromagnetic interference (EMI) radiation noise of a double-layered PCB having a high-impedance power trace structure from being generated much more than in a multilayered-PCB (e.g., a four-layered PCB). That is, since the ground plane 3 does not have a trace structure, but has a planar structure, it has a large space through which current can pass. Accordingly, the ground plate 3 exhibits reduced resistance, thereby reducing generation of radiated EMI, namely, noise.

The decoupling capacitor 4 can be mounted in the vicinity of power/ground pins of an integrated circuit (IC) such as component 6, such that it serves as a power storage device to stably provide the IC with power. For example, referring to FIG. 1, it can be seen that the decoupling capacitor 4 is mounted at the back side of the power pin of component 6. In FIG. 1, the pin connected to the component 6 is illustrated as the power/ground pin. In order to reduce a noise component, such as loop inductance, when the decoupling capacitor 4 is mounted to the PCB, the decoupling capacitor 4 is mounted as close as possible to the power/ground pins of the IC. However, in the case where the power/ground pins and the decoupling capacitor 4 are mounted to the same substrate, the decoupling capacitor 4 and a pad of the power pin need to be spaced apart from each other by a predetermined distance (e.g., 3mm or more), due to a design rule check (DRC) error on OrCAD tools. Thus, when the decoupling capacitor 4 and the pad of the power pin are narrowly spaced apart from each other by a distance shorter than the predetermined distance of certain design tools, an error may be generated. However, in an exemplary embodiment of the present general inventive concept, the component 6 can be mounted to the second substrate 8, and the decoupling capacitor 4 can be mounted close to the power pin of the component 6 on the first substrate 7, such that a distance from the power pin and the decoupling capacitor 4 is reduced to, for example, 1.6mm, without generating the DRC error, corresponding to the height of a via of the PCB 1, such that simultaneous switching noise (SSN) is also reduced. In this case, the via height is equal to the height of the PCB, however, this is not limitation, and the height of the via, as well as the spacing of the component 6 and the decoupling capacitor 4 may be variable.

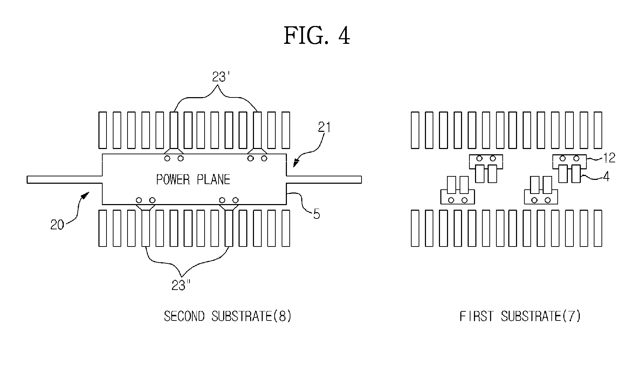

Referring to FIGS. 1 and 4, the power plane 5 having a size similar to that of the component 6 can be installed on the bottom of the component 6 mounted to the second substrate 8 (for example, interposed between the component 6 and the second substrate 8), such that it reduces the SSN caused by a complicated mounting structure of the trace. In the conventional art, the power trace has been designed to have a low impedance so as to reduce power noise. In order to implement the low-impedance power trace, a multilayered PCB having at least four layers is manufactured, such that one of the four layers is designed to be used as a power layer. However, in the conventional art, the power trace needs to be designed on the double-layered PCB (for example, similar to the PCB 1), such that power is provided to the PCB through the power trace. As a result, power/ground noise caused by the high-impedance characteristics of the conventional trace structure is increased, thereby generating much more EMI radiation noise than in the multilayered PCB having at least four layers. In order to prevent the EMI radiation noise from being generated in the double-layered PCB, the power plane 5 can be mounted to the bottom of the component 6, thereby reducing the complexity of the power trace, such that the EMI radiation noise of the component 6 is minimized.

The component 6 may include a variety of through-hole-based circuit elements, for example, a dual-inline package (DIP), a pin grid array (PGA) package, a chip scale package (CSP), and a through-hole array connector. A plurality of pins may be arranged on the top of the component 6 (for example, facing away from a PCB), and a plurality of pins may be arranged on the bottom of the component 6 (for example, facing a PCB). For example, a selected one of the plural pins of component 6, namely, the power pin, can be connected to the power plane. The pins may be arranged in the form of a grid pattern on individual surfaces of the component 6, although the present general inventive concept is not limited thereto. The component 6 may be manufactured for general purposes, may have a predetermined-length pin suitable for the PCB having only through-holes, and the pins may have a proper length using various methods. For example, the pins may be cut to a proper length using a diamond saw or a laser cutter, or may be ground to have a desired length. In addition, the pins may be manufactured by manufacturers to have a proper length. In an exemplary embodiment of the present general inventive concept, one component 6 mounted to the first substrate 7 can be limited to the decoupling capacitor 4, and other components 6 can each be mounted to the second substrate 8, so as to prevent the PCB 1 from generating generates much more EMI radiation noise than the multilayered PCB. In more detail, when several components 6, such as are mounted to the PCB 1, for example, without any rules, they may not have a stable return current path of a high-speed trace as in DDR clock, USB, HDMI, etc., and may cause SSN due to the high-impedance power trace structure, such that the PCB may generate much more EMI radiation than a multilayered-PCB.

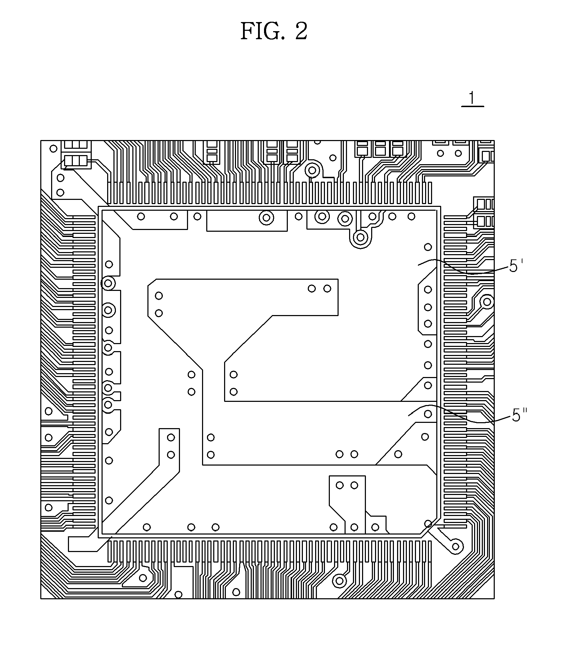

FIG. 2 is a bottom view of the PCB 1 according to an exemplary embodiment of the present general inventive concept.

Referring to FIG. 2, the power planes (5', 5") can be arranged on the bottom the component 6 at a position where the component 6 is mounted to the PCB 1. The power plane (5',5") of FIG. 2 can be classified into two kinds of power planes, for example, a first power plane 5' for providing a pin of a component such as component 6 requiring high power (e.g., 3.3V) with power and a second power plane 5" for providing another pin of a component such as component 6 requiring low power (e.g., 1.8V) with power. As described above, the power planes 5' and 5" instead of the power trace can be located under the component 6, so that impedance is reduced. As a result, power trace's inductance creating noise due to, for example, loop inductance in the supply of power, may also be reduced. A plurality of power planes to supply powers of different levels may be installed.

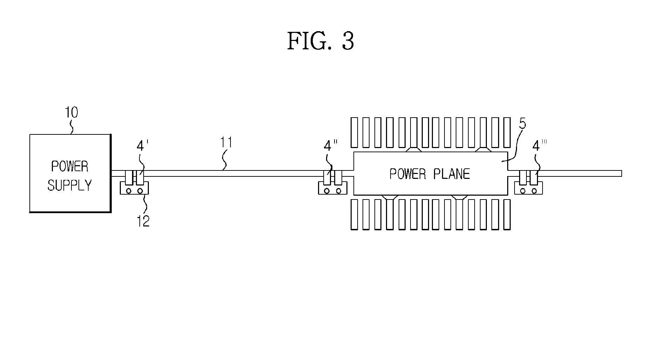

FIG. 3 illustrates a position of a decoupling capacitor 4 mounted to a PCB according to an exemplary embodiment of the present general inventive concept.

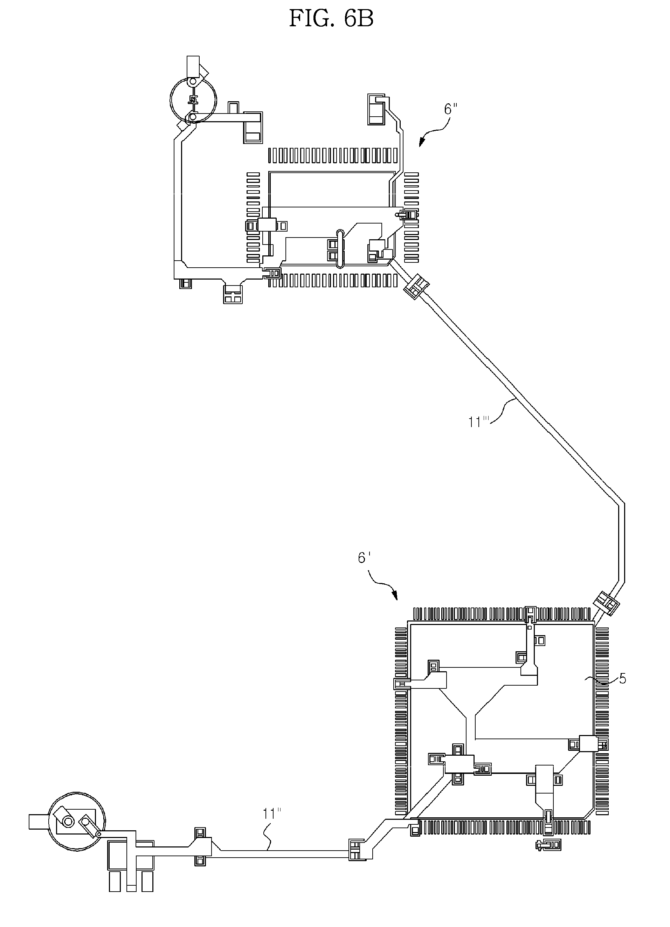

Referring to FIG. 3, a power supply 10 mounted to the second substrate 8 can be connected to the power plane 5 mounted to the bottom of a component 6 via the power trace 11. A first decoupling capacitor 4' can be mounted in the vicinity of an output point of the power supply 10 to output the power, and a second decoupling capacitor 4" can be mounted to a power trace 11 (i.e., an input point of the power plane 5) which is located just before the power trace 11 enters the power plane 5. In other words, in order to reduce noise, also known as loop inductance of the power trace 11, the decoupling capacitors 4' and 4" can be mounted to the closest position possible to the power/ground pins of the IC. Meanwhile, a third decoupling capacitor 4'" can be mounted at an output point of the power trace 11 ranging from the power plane 5 located under the component 6 mounted on the second substrate 8 to another power plane 5', such as illustrated in FIG. 6B. In an exemplary embodiment, the decoupling capacitors 4', 4", and 4'" mounted to the second substrate 8 can be connected to the ground plane 3 of the first substrate through a via 12. The via 12 can be connected to the power plane 5 of the first substrate 7, as illustrated in FIG. 1. It is noted that in exemplary embodiments of the present general inventive concept, the decoupling capacitors can be mounted to both the first substrate and the second substrate. The decoupling capacitors mounted to the second substrate can be installed at the power input and output units of the power plane. The decoupling capacitors mounted to the first substrate can be connected to the input and output terminals of the power supply or power plane. The decoupling capacitor mounted to the first substrate can be connected to the power pin of a component.

FIG. 4 illustrates a position of the decoupling capacitor 4 of PCB 1 mounted to the PCB 1 according to an exemplary embodiment of the present general inventive concept.

Referring to FIG. 4, the power plane 5 may include a power input unit 20 for receiving power, for example, from the power supply 10, and a power output unit 21 for outputting power provided from the power supply 10, to transmit power to a component 6 (FIG. 1). The power input unit 20 is a stage, through which power can be input to the power plane 5 mounted to the bottom of the component 6. The power output unit 21 is a stage, through which power can be output from the power plane 5.

Power pins 23' and 23" connected to the power plane 5 of the second substrate 8 can be connected to the decoupling capacitor 4 of the first substrate 7 through the via 12. In this way, if the decoupling capacitor 4 is connected to the power pins 23' and 23", the distance between the power pin and the decoupling capacitor 4 can be reduced to, for example, 1.6mm, corresponding to the height of via 12, thereby reducing simultaneous switching noise (SSN) and without generating a DRC error.

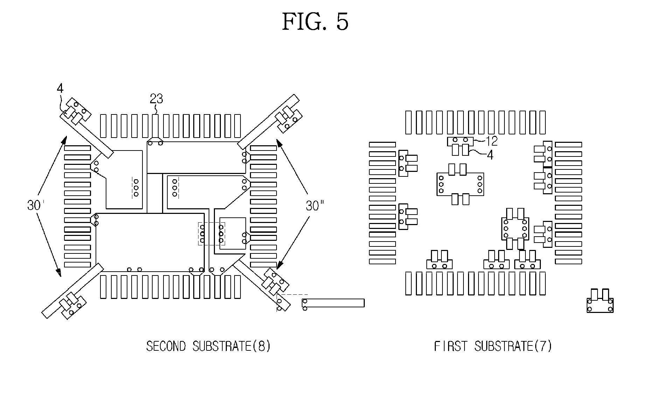

FIG. 5 illustrates an installation structure of the decoupling capacitor 4 of a component according to an exemplary embodiment of the present general inventive concept.

Referring to FIG. 5, if the PCB 1 uses two kinds of power (for example, a high power and a low power), power traces 11' to transmit each kind of power through an edge 30' of a component 6' having no pins may be input, and two kinds of power traces 11" to transmit power to another component 6" may be output through an edge 30" of the component having no pins. The decoupling capacitor 4 may be mounted in the vicinity of not only the edge 30' of the component 6' where the power trace 11' of the power plane 5 is input, but also the other edge 30" where the power trace 11" is output to the component 6".

The power plane 5 of the second substrate 8 can be connected to the decoupling capacitor 4 of the first substrate 7 through the via 12, such that the distance between the power pins 23 and the decoupling capacitor 4 is reduced to, for example, about 1.6mm, thereby minimizing the SSN.

Although the component 6 may use only one kind of power, the power trace 11 may be routed via the edge 30' or 30" having no pins using the above-mentioned method.

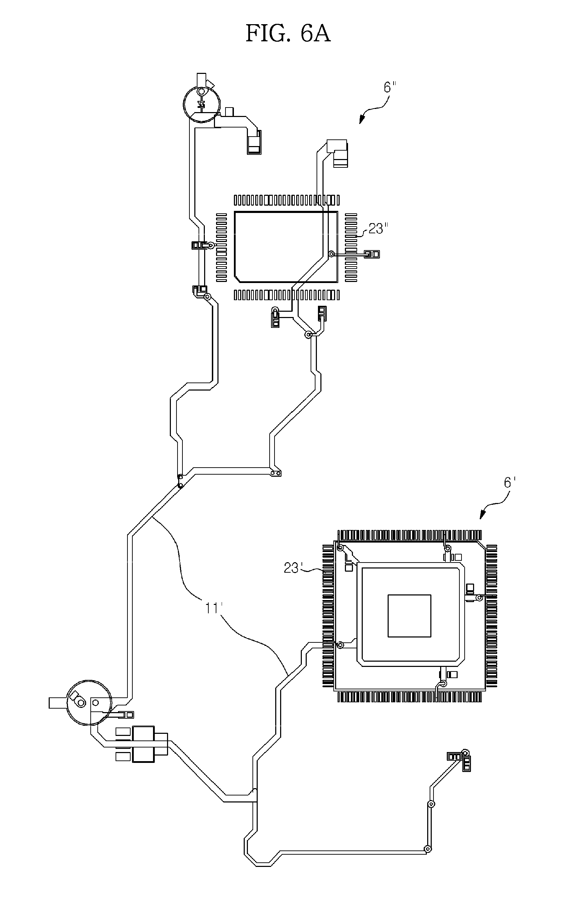

FIG. 6A illustrates a power trace of a PCB 600A according to the conventional art.

FIG. 6B illustrates a power trace of a PCB 600B according to an exemplary embodiment of the present general inventive concept.

In detail, the power trace 11' of FIG. 6A is formed when the power transmitted to the component 6', 6" is directly applied to the power pins 23', 23" through the power trace 11'. In contrast, the power trace 11" of FIG. 6B can be formed when the power transmitted to the component 6' is transmitted to the power plane 5 located under the component 6' through the power trace 11, and the power transmitted to another component 6" is transmitted through the power trace 11"' directly output from the power plane 5.

As can be seen from FIGS. 6A and 6B, power can be transmitted to several components 6' and 6" on the PCB, such that the power trace 11 is greatly simplified in structure. FIGS. 6A and 6B illustrate two components 6' and 6" mounted to the PCB. In contrast, if two or more components 6 are mounted to the PCB, the power trace 11 may be more simplified than in the PCB including only two components.

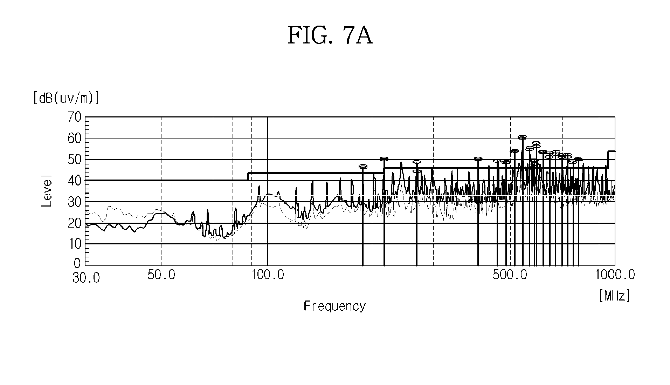

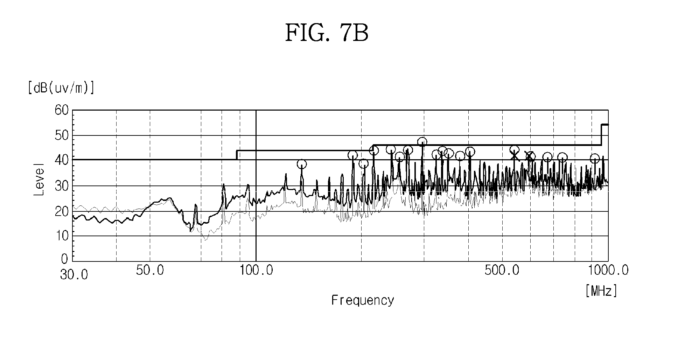

FIGS. 7A and 7B are graphs illustrating EMI data of the PCB 1 according to an exemplary embodiment of the present general inventive concept.

FIG. 7A illustrate an amount of radiation differently emitted according to the frequency of power on the PCB 1 when the component 6 of the PCB 1 receives power through the power trace 11. In FIG. 7B, when the power plane 5 is formed under the component 6 of the PCB 1 and constituent components are arranged to transmit power using the method above, an amount of radiation differently emitted according to the frequency of power on the PCB 1 is illustrated.

As illustrated in FIGS. 7A and 7B, the PCB generates radiation of 50 [dB(uv/m)] - 60[dB(uv/m)] at a power frequency of 300MHz ∼ 1000MHz before the power structure of the PCB is changed. However, after the power structure of the PCB 1 is changed using the method described herein, the PCB 1 generates radiation of 50 [dB(uv/m)] or less at the power frequency of 300MHz ∼ 1000MHz.

As is apparent from the above description, the PCB according to exemplary embodiments of the present general inventive concept simplifies the power trace, such that SSN generated from the PCB is reduced.

The PCB according to exemplary embodiments of the present general inventive concept has an improved decoupling capacitor connection structure, thereby reducing the SSN.

Although a few embodiments of the present general inventive concept have been illustrated and described, it will be appreciated by those skilled in the art that changes may be made in these exemplary embodiments without departing from the principles and spirit of the general inventive concept, the scope of which is defined in the claims and their equivalents.

## Claims

1. A double-layered printed circuit board (PCB) in which a first substrate is arranged parallel to a second substrate and is spaced apart from the second substrate by a predetermined distance, comprising:
the first substrate including a ground plane deposited over the first substrate; and
the second substrate including a power plane deposited at a position of a component mounted to the printed circuit board (PCB) to transmit power to the component.

2. The printed circuit board (PCB) according to claim 1, wherein the second substrate includes a signal trace and a power trace to transmit signals and power to the component.

3. The printed circuit board (PCB) according to claim 2, wherein the power trace is connected to the power plane through an edge having no pin connected to the component.

4. The printed circuit board (PCB) according to claim 1, wherein the first substrate further includes a decoupling capacitor, and a power pin of the component mounted to the second substrate is connected to the decoupling capacitor through a via.

5. The printed circuit board (PCB) according to claim 1, wherein the second substrate further includes a power supply to provide the power plane with power, and wherein the power plane is connected to the power supply through a power trace.

6. The printed circuit board (PCB) according to claim 5, further comprising:
a decoupling capacitor is mounted to a start point of the power trace to transmit power from the power supply to the power plane.

7. The printed circuit board (PCB) according to claim 5, further comprising:
a decoupling capacitor is mounted to an end point of the power trace to transmit power from the power supply to the power plane, wherein the power plane is interposed between the component and the substrate to transmit power to the component.
